# EUROPÄISCHE PATENTSCHRIFT

(11) **EP 1 189 337 B1**
(45) Veröffentlichungstag und Bekanntmachung des Hinweises auf die Patenterteilung: **13.12.2006**
(21) Anmeldenummer: 01114229.6
(22) Anmeldetag: 12.06.2001
(51) Int. Cl.: H03D 7/14

(54) **Gegentaktmischerschaltung unter Verwendung von bipolaren Transistoren**
Balanced mixer circuit using bipolar transistors
Circuit mélangeur équilibré utilisant transistors bipolaires

(30) Priorität: 31.07.2000 DE 10037247
(43) Veröffentlichungstag der Anmeldung: 20.03.2002
(73) Patentinhaber: Infineon Technologies AG, 81669 München (DE)
(72) Erfinder: Asam, Michael, 85250 Wollomoos (DE)
(74) Vertreter: Epping - Hermann - Fischer

(56) Entgegenhaltungen:
- DE-A- 4 205 486
- US-A- 5 570 056
- US-A- 5 933 771
- SVELTO F ET AL: "A LOW-VOLTAGE TOPOLOGY FOR CMOS RF MIXERS" IEEE TRANSACTIONS ON CONSUMER ELECTRONICS, IEEE INC. NEW YORK, US, Bd. 45, Nr. 2, Mai 1999 (1999-05), Seiten 299-309, XP000908401 ISSN: 0098-3063

## Beschreibung

Die Erfindung betrifft eine Schaltungsanordnung zur Mischung eines Nutzsignals mit einem Oszillatorsignal mit Anschlüssen für komplementäre Signalkomponenten des Nutzsignals und komplementäre Signalkomponenten des Oszillatorsignals, die Differenzverstärker ansteuern.

Schaltungsanordnungen zum Mischen eines Nutzsignals mit einem Oszillatorsignal werden in der Kommunikations- und Nachrichtentechnik häufig eingesetzt, um Nutzsignale von einem Frequenzband in ein anderes Frequenzband umzusetzen. Insbesondere sind empfangene Hochfrequenzsignale auf ein Zwischenfrequenzsignal umzusetzen oder umgekehrt.

Üblicherweise wird hierzu ein Gilbert-Mischer verwendet. Das komplementäre Signalkomponenten umfassende Nutzsignal wird dem Gilbert-Mischer an den Basisanschlüssen zweier über einen Widerstand emittergekoppelter Bipolartransistoren zugeführt. Emitterseitig sind die Transistoren über je eine Stromquelle mit Bezugspotential (Masse) verbunden. Kollektorseitig ist je ein Differenzverstärker angeschlossen, dessen Transistoren von den komplementären Signalkomponenten des Lokaloszillatorsignals angesteuert werden und dessen Kollektorpfade über Kreuz gekoppelt sind. Die Kollektorpfade sind über je einen Lastwiderstand an ein positives Versorgungspotential angeschlossen. Die komplementären Signalanteile des Ausgangssignals werden an den Lastwiderständen abgegriffen.

Beim herkömmlichen Gilbert-Mischer sind zwischen die Anschlüsse für die Versorgungsspannung eine Stromquelle, der vom Nutzsignal angesteuerte Transistor, der vom Lokaloszillatorsignal angesteuerte Transistor sowie das Lastelement in Reihe geschaltet. Dies sind mindestens drei Transistorebenen, wobei berücksichtigt ist, daß die Stromquelle ebenfalls einen Transistor enthält. Problematisch ist daher, daß die anzulegende Versorgungsspannung einen Mindestwert nicht unterschreiten darf. Außerdem läuft das Bestreben nach möglichst niedriger Versorgungsspannung dem Wunsch nach möglichst hoher Amplitude des Ausgangssignals entgegen.

In der DE 42 05 486 A1 ist eine Mischeranordnung gezeigt, bei der zwei Stromschalter ausgangsseitig über Kreuz gekoppelt sind und eingangsseitig parallel angesteuert werden. Die Stromquellen der Stromschalter sind über jeweilige weitere Transistoren, die von einem digitalen Signal ansteuerbar sind, mit der Versorgungsspannung verbunden.

In der DE 41 14 943 A1 ist ein Mischer mit kaskadierten Stromschaltern beschrieben, bei dem der mit der Stromquelle verbundene Stromschalter von einem Frequenzsignal steuerbare Transistoren enthält, die über je einen Widerstand an eine bezugspotentialseitige Stromquelle angeschlossen sind.

In der DE 37 42 537 A1 sind verschiedene Vier-Quadranten-Gilbert-Modulatoren gezeigt mit bezugspotentialseitigen Stromquellen und einem Differenzverstärker. Die Zweige des Differenzverstärkers sind über Widerstände gekoppelt.

Das Dokument US 5 570 056 beschreibt einen Analogschaltkreis zum Multiplizieren eines ersten Eingangssignals mit einem zweiten Eingangssignal. Der Schaltkreis weist ein erstes und ein zweites Transistorpaar auf, das als erstes und zweites Differentialpaar gekoppelt ist. Das erste Transistorpaar wird von einem positiven Zwischenfrequenzsignal IF und das zweite von einem negativen Zwischenfrequenzsignal NIF gesteuert. Ein erster Transistor eines dritten Transistorpaares wird von einem positiven Lokaloszillatorsignal LO, ein zweiter von einem negativen Lokaloszillatorsignal NLO gesteuert. Die sechs Transistoren sind kollektorseitig mittels Widerstände untereinander sowie an einen Pluspol einer Spannungsquelle und emitterseitig mittels Widerstände untereinander sowie an ein Massepotential derart gekoppelt, dass ein positives und ein negatives Radiofrequenzsignal RF beziehungsweise NRF als Funktion der Zwischenfrequenzsignale IF beziehungsweise NIF und der Lokaloszillatorsignale LO beziehungsweise NLO abgreifbar ist.

Die Aufgabe der vorliegenden Erfindung besteht darin, eine Schaltungsanordnung zum Mischen eines Nutzsignals mit einem Oszillatorsignal anzugeben, welche bei möglichst niedriger Versorgungsspannung betrieben werden kann.

Gemäß der Erfindung wird diese Aufgabe durch eine Schaltungsanordnung nach Patentanspruch 1 gelöst.

Alternativ wird diese Aufgabe durch einen Schaltungsanordnung nach Patentanspruch 6 gelöst.

Der Mischer gemäß der Erfindung hat nunmehr nur noch zwei Transistorebenen, die zwischen die Versorgungsspannung geschaltet sind. So sind die Differenzverstärker über eine Stromquelle an Bezugspotential (Masse) angeschlossen. Kollektorseitig sind die Differenzverstärker über das Lastelement an die Versorgungsspannung angeschlossen. Verglichen mit einem herkömmlichen Gilbert-Mischer wird nicht nur die erforderliche Mindestversorgungsspannung verringert, es ist auch die erforderliche Anzahl von Transistoren niedriger

Gegenüber einem herkömmlichen Gilbert-Mischer besteht ein Wirkungsprinzip der Schaltung gemäß der Erfindung darin, daß der durch die vom Nutzsignal angesteuerten Transistoren der Differenzverstärker fließende Strom in Abhängigkeit vom Oszillatorsignal geschaltet wird. Demgegenüber sind bei einem Gilbert-Mischer die vom Nutzsignal angesteuerten Transistoren stets von Strom durchflossen. Anstelle der eher vertikalen Struktur des Gilbert-Mischer besitzt der Mischer gemäß der Erfindung eine vielmehr horizontale Struktur, bei der die vom Nutzsignal angesteuerten Differenzverstärker eingangsseitig parallel zueinander angesteuert werden und kollektorseitig antiparallel oder über Kreuz gekoppelt an den Lastwiderständen zusammengefaßt werden. Die Differenzverstärker sind bezüglich des zu mischenden Nutzsignals eingangsseitig parallel geschaltet; ausgangsseitig sind die Kollektorzweige der Differenzverstärker antiparallel geschaltet und über Kreuz miteinander verkoppelt. D.h. ein von einer ersten Signalkomponente des Nutzsignals angesteuerter Zweig eines Differenzverstärkers ist mit dem von der anderen Signalkomponente des Nutzsignals angesteuerten Zweig des anderen Differenzverstärkers gekoppelt.

Verschiedene Ausgestaltungen, die Gegenstand der beiden unabhängigen Patentansprüche sind, werden nachfolgend beschrieben.

Die beiden Zweige der Differenzverstärker sind jeweils an einem Kopplungsknoten verbunden, welcher über eine Stromquelle an den Anschluß für Bezugspotential, praktischerweise Masse, angeschlossen ist. Die Stromquellen sind in einer Ausführung der Erfindung steuerbar. Die Größe des eingeprägten Stroms wird von je einer der komplementären Komponenten des Oszillatorsignals angesteuert. Bei im wesentlichen digital verlaufendem Oszillatorsignal werden die von den Stromquellen bereitgestellten Ströme ein- und ausgeschaltet. Beide Stromquellen werden dabei gegenphasig, d.h. abwechselnd ein- bzw. ausgeschaltet. Je nach dem Vorzeichen der die Stromquelle steuernden Oszillatorsignalkomponente wird die Phase des linearen Signals am Ausgang um 0° oder 180° gedreht. Dies entspricht dem vergleichbaren Mischungsvorgang in einem Gilbert-Mischer.

Es ist gemäß einer anderen Ausführungsform der Erfindung auch möglich, einen Differenzverstärker über eine Konstantstromquelle mit dem Anschluß für das Bezugspotential zu verbinden und innerhalb des Differenzverstärkers einen an den Anschluß für das Versorgungspotential geführten Strompfad vorzusehen. Dieser Bypass-Strompfad ist von einer der Komponenten des Oszillatorsignals steuerbar, um den Strom an den vom Nutzsignal angesteuerten Transistoren der Differenzverstärkerzweige vorbei direkt an den Anschluß für das Versorgungspotential zu führen. Zweckmäßigerweise ist hierzu für jeden der Zweige des Differenzverstärkers ein weiterer Transistor vorgesehen, dessen Hauptstrompfad mit dem Hauptstrompfad eines der Transistoren des Differenzverstärkerzweigs verbunden ist und außerdem an den Anschluß für das Versorgungspotential angeschlossen ist. Diese Ausführung weist ein besonders schnelles Schaltverhalten bezüglich des Ein- und Ausschaltens des den Transistoren des Differenzverstärkers zuführbaren Stromes auf. Die Schaltung kann daher bei hohen Oszillatorsignalfrequenzen betrieben werden. Die Bypass-Transistoren sind bezüglich der sie ansteuernden Signalkomponente des Oszillatorsignals Emitterfolgertransistoren, (bzw. Sourcefolgertransistoren bei Realisierung mit MOS-Transistoren), die das Emitterpotential (Sourcepotential) der vom Nutzsignal angesteuerten Transistoren anheben und dadurch sperren. Der von der Konstantstromquelle eingeprägte Strom wird dann von den vom Nutzsignal angesteuerten Transistoren der Differenzverstärkerzweige umgeleitet zu den durch die Emitterfolger (Sourcefolger) gebildeten Strompfade. Das schnelle Umschalten des Stroms bewirkt ein gutes Rauschverhalten des erzeugten Ausgangssignals.

Eine besonders vorteilhafte Ausführung besteht darin, daß die Fußpunkte der beiden Differenzverstärker, d.h. die Kopplungsknoten der Zweige der Differenzverstärker, einen gemeinsamen Knoten bilden, der über eine gemeinsame Stromquelle mit dem Anschluß für das Bezugspotential verbunden ist. Die jeweiligen Stromquellen der Differenzverstärker werden also durch eine einzige Stromquelle gebildet. Zusätzlich werden die Komponenten des Lokaloszillatorsignals über jeweilige kapazitive Elemente an die Steueranschlüsse der Transistoren der Differenzverstärker angeschlossen. Als Bypass-Transistoren eines der Differenzverstärker wirken dann die jeweiligen Transistoren des anderen Differenzverstärkers. Dies hat den Vorteil, nur noch eine einzige Stromquelle erforderlich ist, so daß Strom und Verlustleistung gespart werden. Darüber hinaus sind weniger Transistoren erforderlich. Die in dieser Ausgestaltung miteinander gekoppelten Basisanschlüsse der Transistoren sind über jeweilige Widerstände voneinander entkoppelt. Anstelle der Widerstände können auch Induktivitäten vorgesehen werden. Die Komponenten des Oszillatorsignals sind dann mittels gekoppelter Spulen (Trafo) anstelle von kapazitiven Elementen zuzuführen.

Eine vorteilhafte Weiterbildung der Erfindung besteht darin, daß die Lastelemente aktive Komponenten enthalten, so daß ein Mischer mit variabler Verstärkung gebildet wird. So umfaßt ein Lastelement einen weiteren Differenzverstärker, dessen Fußpunkt mit den gekoppelten Zweigen der anderen Differenzverstärker verbunden ist und der lastseitig in einem seiner Zweige ein weiteres Lastelement enthält, das an den Anschluß für das Versorgungspotential angeschlossen ist. Die beiden anderen Zweige dieser lastseitigen Differenzverstärker sind miteinander gekoppelt und an den Anschluß für das Versorgungspotential angeschlossen. Ein Steuersignal, das parallel die jeweils paarweise einander entsprechenden Zweige dieser Differenzverstärker ansteuert, dient zur variablen Einstellung der Verstärkung des Mischers. Dadurch, daß für die Mischerzelle selbst nur zwei Transistorebenen erforderlich sind, wird trotz Hinzufügung der dritten Transistorebene zur variablen Verstärkungseinstellung keine im Vergleich zur Gilbert-Zelle höhere Versorgungsspannung erforderlich. Die Schaltung kann bei einer typischen Versorgungsspannung von 2,7 Volt betrieben werden.

Nachfolgend wird die Erfindung anhand der in der Zeichnung dargestellten Ausführungsbeispiele näher beschrieben. Entsprechende Elemente in verschiedenen Figuren werden mit gleichen Bezugszeichen versehen. Es zeigen:
- Figur 1: eine Schaltung gemäß einer ersten Ausführungsform,
- Figur 2: eine Schaltung gemäß einer zweiten Ausführungsform mit Bypass-Emitterfolgertransistoren,
- Figur 3: eine Ausführungsform mit einziger Stromquelle und
- Figur 4: eine Ausführungsform mit einziger Stromquelle und variabler Verstärkungseinstellung.

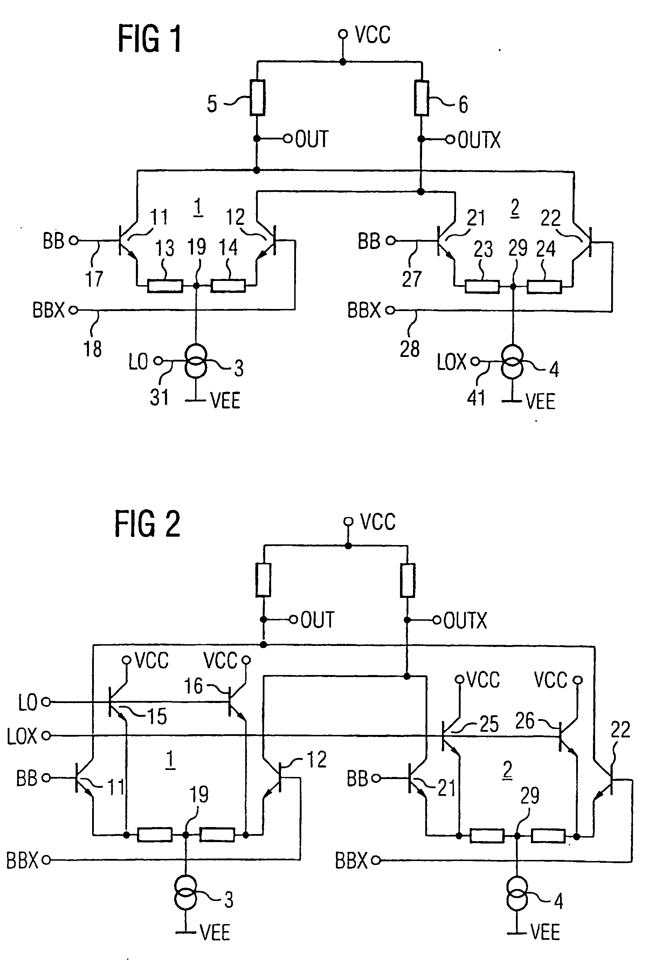

Der in Figur 1 gezeigte Vier-Quadranten-Mischer weist Eingangsanschlüsse 17, 18, 27, 28 für ein mit einem Oszillatorsignal LO, LOX zu mischendes Nutzsignal BB, BBX auf. Das differentielle Nutzsignal weist zueinander komplementäre Komponenten BB und BBX auf. Die In-Phasen-Komponente wird an den Anschlüssen 17, 27 bereitgestellt, die Gegen-Phasen-Komponente BBX wird an Anschlüssen 18, 28 bereitgestellt. Das Oszillatorsignal ist ein differentielles Signal mit In-Phasen-Komponente LO und Gegen-Phasen-Komponente LOX, die an Anschlüssen 31 bzw. 41 bereitgestellt werden. Es sind zwei Differenzverstärker 1, 2 vorgesehen mit jeweiligen Signalpfaden 11, 12 bzw. 21, 22, die an einem Kopplungsknoten 19, 29 miteinander gekoppelt sind. Die Differenzverstärkerzweige weisen den Hauptstrompfad je eines Transistors auf. Die Hauptstrompfade von Bipolartransistoren sind deren Kollektor-Emitter-Strecke. Emitterseitig ist je ein Widerstand 13, 14 vorgesehen, die am Knoten 19 miteinander verbunden sind. Der Fußpunkt 19 des Differenzverstärkers 1 ist über eine Stromquelle 3 mit einem Bezugspotential VEE, welches Masse sein kann, verbunden. Einen entsprechenden Aufbau weist der Differenzverstärker 2 mit zwei Bipolartransistoren 21, 22, zwei Gegenkopplungswiderständen 23, 24 in deren Emitterpfad, einem Kopplungsknoten 29 sowie einer diesen Kopplungsknoten 29 mit Masse verbindenden Stromquelle 4 auf. Einer der Transistoren der Differenzverstärker, z.B. die Transistoren 11, 21, wird vom der Signalkomponente BB angesteuert, der jeweils andere der Transistor, z.B. die Transistoren 12, 22, wird von der Signalkomponente BBX angesteuert. Eingangsseitig sind daher die Differenzverstärker 1, 2 parallel geschaltet.

Die Kollektorpfad der Zweige des Differenzverstärkers sind über Kreuz oder antiparallel miteinander verschaltet. So ist der Kollektor des vom Signal BB angesteuerten Transistors 11 des Differenzverstärkers 1 mit dem Kollektor des vom Signal BBX angesteuerten Transistors 22 des Differenzverstärkers 2 gekoppelt. Entsprechend sind die Kollektoren der Transistoren 12, 21 gekoppelt. Diese ausgangsseitigen Kopplungsknoten werden über je einen Lastwiderstand 5, 6 mit dem Anschluß für das gegenüber dem Massepotential VEE positive Versorgungspotential VCC verbunden. Ein Ausgangsanschluß für die In-Phasen-Komponente OUT ist an den Widerstand 5, ein Ausgangsanschluß für die Gegen-Phasen-Komponente OUTX ist an den Widerstand 6 angeschlossen. Die Stromquellen 3, 4 sind steuerbare Stromquellen, d.h. deren eingeprägter Strom ist in Abhängigkeit von einem Steuersignal einstellbar. So wird die Stromquelle 3 vom am Anschluß 31 anliegenden Lokaloszillatorsignal LO gesteuert, die Stromquelle 4 vom am Anschluß 41 anliegenden dazu gegenphasigen Lokaloszillatorsignal LOX.

Durch abwechselndes Ein- und Ausschalten der Stromquellen 3, 4 durch die im wesentlichen rechteckförmigen, digitalen Signalkomponente des Lokaloszillatorsignals LO, LOX wird abwechselnd der Differenzverstärker 1 oder der Differenzverstärker 2 mit Strom versorgt. Die differentiellen Signalkomponenten BB, BBX des linearen, analogen Nutzsignals werden dadurch mit dem Lokaloszillatorsignal LO, LOX gemischt und um die Frequenz des Lokaloszillatorsignals umgesetzt und als Ausgangssignal OUT, OUTX ausgegeben. Es ist nur eine der Stromquellen aktiv. Je nach Lage des Vorzeichens des LO/LOX-Signals zum linearen Eingangssignal BB/BBX wird die Phase des linearen Signals am Ausgang um 0° bzw. 180° gedreht. Prinzipiell sind die Differenzverstärker 1, 2 eingangsseitig parallel geschaltet und ausgangsseitig antiparallel geschaltet, wobei das Lokaloszillatorsignal zwischen den die Differenzverstärker speisenden Stromquellen umschaltet.

Die Schaltung weist nur zwei Transistorebenen auf, einerseits die durch die Transistoren 11, 12, 21, 22 gebildete Transistorebene und anderseits die durch die in den Stromquellen 3, 4 enthaltenden Transistoren gebildete Transistorebene. Die zwischen Masse VEE und dem positiven Versorgungspotential VCC anliegende Spannung kann daher relativ niedrig gewählt werden. Andererseits besteht genügend Spannungsreserve, um an den Lastwiderständen 5, 6 eine hinreichend große Amplitude des differentiellen Ausgangssignals vorzusehen.

Die in der Figur 2 gezeigte Ausführungsform weist wie in Figur 1 die Differenzverstärker 1, 2 auf, deren Fußpunkte 19, 29 über die Stromquellen 3, 4 mit Masse verbunden sind. Abweichend von der Ausführungsform in Figur 1 sind die Stromquellen 3, 4 als Konstantstromquellen ausgeführt. Daher sind zusätzlich Strompfade 15, 16 vorgesehen, die den am Fußpunkt 19 eingeprägten Konstantstrom in Abhängigkeit von der jeweilige Komponente des Lokaloszillatorsignals LO, LOX an die Versorgungsspannung VCC abführen. Der Emitter des Transistors 11 des einen Zweigs des Differenzverstärkers 1 ist mit dem Emitter eines weiteren Transistors 15 gekoppelt. Der Kollektor des Transistors 15 ist an den Anschluß für das Versorgungspotential VCC angeschlossen. Der Emitter des Transistors 12 des anderen Zweigs des Differenzverstärkers 1 ist mit dem Emitter eines anderen Transistors 16 verbunden. Der Kollektor des Transistors 16 ist an den Anschluß für das Versorgungspotential VCC angeschlossen. Die Emitter der Transistoren 15 und 16 sind nur mittelbar mit der Stromquelle 3 verbunden. Die Stromquelle 3 ist über jeweilige Widerstände an die Emitter der Transistoren 11, 12 angeschlossen. Die Basisanschlüsse der Transistoren 15, 16 werden gemeinsam von der In-Phasen-Komponente LO des Lokaloszillatorsignals gesteuert. In entsprechender Weise sind für den Differenzverstärker 2 jeweilige Transistoren 25, 26 vorgesehen, die von der Gegen-Phasen-Komponente LOX des Lokaloszillatorsignals angesteuert werden. Die Transistoren 25, 26 sind einerseits an die Emitteranschlüsse der Differenzverstärkertransistoren 21, 22 angeschlossen und andererseits an das Versorgungspotential VCC. Die Differenzverstärkertransistoren 21, 22 sind über jeweilige Widerstände unmittelbar an die Stromquelle 4 angeschlossen.

Während die Stromquellen 3, 4 in Figur 2 einen konstanten Gleichstrom liefern, werden die Ströme in Abhängigkeit der Steuerung durch die Komponenten LO, LOX des Lokaloszillatorsignals von den Differenzverstärkertransistoren 11, 12 bzw. 21, 22 weggeschaltet und an das Versorgungspotential VCC abgeführt. Die diese Bypass-Pfade bildenden Transistoren 15, 16 bzw. 25, 26 wirken als Emitterfolgertransistoren. Beispielsweise heben die Transistoren 15, 16 dann, wenn das Signal LO einen High-Pegel aufweist, das Emitterpotential der Transistoren 11, 12 ausreichend an, so daß die Transistoren 11, 12 während der High-Phase des Signals LO gesperrt sind. Der von der Stromquelle 3 eingeprägter Strom wird dann von den Transistoren 11, 12 ferngehalten und über die Transistoren 15, 16 abgeführt. Die Transistoren 25, 26 im Differenzverstärker 2 werden vom Signal LOX gegenphasig zum Signal LO angesteuert. Somit wird verglichen mit der Schaltung der Figur 1 der gleiche Effekt erreicht, daß abwechselnd nur der Strom durch den Differenzverstärker 1 im Ausgangssignal OUT, OUTX wirksam wird oder der Strom durch den Differenzverstärker 2. Vorteilhafterweise wird gegenüber der Schaltung in Figur 1 wird durch die Ausführung in Figur 2 die Schaltgeschwindigkeit erhöht. Wegen der steileren Schaltflanken ist das Rauschverhalten des Verstärkers besser, d.h. der Rauschanteil im Ausgangssignal OUT, OUTX ist verringert.

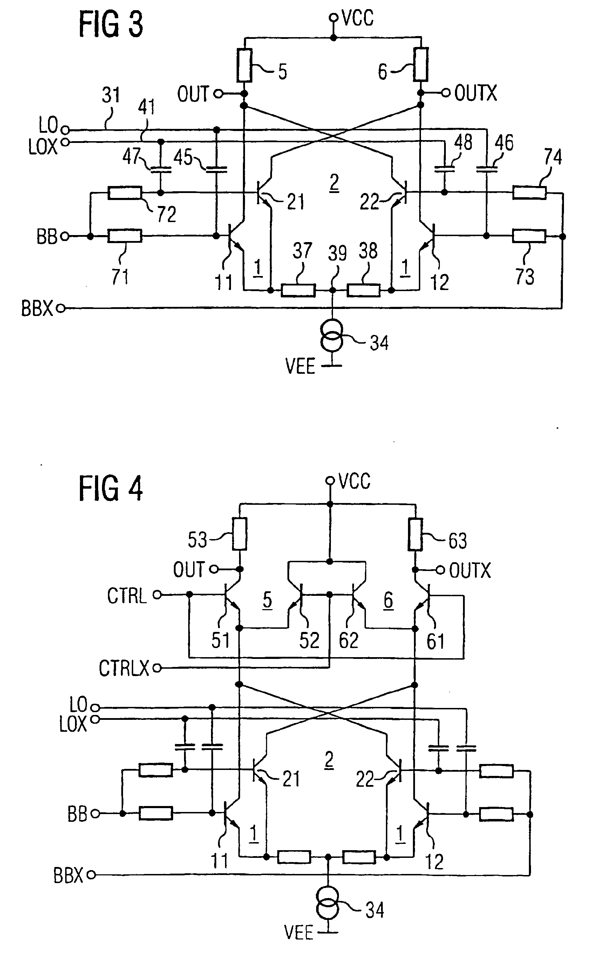

Bei der in Figur 3 dargestellten Ausführungsform haben die Differenzverstärker 1, 2 einen gemeinsamen Fußpunkt 39. Somit sind die Transistoren 11, 12 des ersten Differenzverstärkers 1 über jeweilige Widerstände 37 bzw. 38 an den Knoten 39 gekoppelt. Die Transistoren 21, 22 des Differenzverstärkers 2 sind ebenfalls über die Widerstände 37 bzw. 38 an den Knoten 39 gekoppelt. Der Knoten 39 ist über eine einzige Konstantstromquelle 34 mit dem Bezugspotential VEE verbunden. Die Basisanschlüsse der Transistoren 11, 21 werden von der Signalkomponente BB angesteuert, die Basisanschlüsse der Transistoren 12, 22 von der Signalkomponente BBX. Zur Entkopplung der Basisanschlüsse sind jeweilige Widerstände 71, 72 bzw. 73, 74 vorgesehen. Die Kollektoranschlüsse der Transistoren sind über Kreuz gekoppelt. So sind die Kollektoren der Transistoren 21, 12 miteinander an den Widerstand 6 angeschlossen, die Kollektoren der Transistoren 11, 22 miteinander an den Widerstand 5. Die Komponenten LO, LOX des Lokaloszillatorsignals werden über kapazitive Elemente an die Basisanschlüsse der Transistoren angelegt. Das Signal LO wird über Kondensatoren 45, 46 an die Basisanschlüsse der Transistoren 11, 12 des Differenzverstärkers 1 angelegt, das Signal LOX über Kondensatoren 47, 48 an die Basisanschlüsse der Transistoren 21, 22 des Differenzverstärkers 2.

Verglichen mit der Ausführung in Figur 2 dienen die Transistoren des gerade aktiv geschalteten Differenzverstärkers als Bypass-Transistoren für den anderen Differenzverstärker. Die Komponenten LO, LOX des Lokaloszillatorsignals werden über die kapazitiven Elemente 45, ..., 48 an die Basisanschlüsse der Transistoren 11, 12, 21, 22 gekoppelt. Bei einem Low-Pegel, beispielsweise des Signals LO, wird das Basispotential der Transistoren 11, 12 soweit abgesenkt, daß die Transistoren 11, 12 gesperrt sind und der von der Stromquelle 34 eingeprägte Strom nur über die Transistoren 21, 22 des Differenzverstärkers 2 fließt. Währenddessen hat das Signal LOX einen H-Pegel, so daß das Basispotential der Transistoren 21, 22 soweit angehoben ist, daß sie sicher leitend sind. Entsprechend umgekehrte Verhältnisse liegen vor, wenn das Signal LO einen High-Pegel aufweist. Der Differenzverstärker mit den momentan niedrigeren Basispotentialen ist abgeschaltet, der Differenzverstärker mit den momentan höheren Baispotentialen führt den Strom. Auch hier wird ein sehr schnelles Umschaltverhalten erreicht.

Die Widerstände 71, ..., 74 können auch durch Induktivitäten ersetzt werden. Dann sind die Signale LO, LOX mit Hilfe gekoppelter Spulen (Trafo) anstelle der Kapazitäten 45, .., 48 zuzuführen. Vorteilhafterweise wird nur eine Stromquelle benötigt, so daß Strom gespart wird.

Der in Figur 4 gezeigte Mischer basiert auf dem in Figur 3 gezeigten Mischer, wobei die Lasten 5, 6 aktiv sind, um eine über komplementäre Komponenten eines Steuersignals CTRL, CTRLX einstellbare Verstärkung zu bewirken. Ein Differenzverstärker 6 mit emittergekoppelten Transistoren 61, 62 ist mit einem der ausgangsseitigen Kopplungsknoten der Differenzverstärker 1, 2 verbunden, ein anderer Differenzverstärker 5, umfassend emittergekoppelte Transistoren 51, 52, mit dem anderen ausgangsseitigen Kopplungsknoten der Differenzverstärker 1, 2. Die Basisanschlüsse der Transistoren 51, 61 werden vom Steuersignal CTRL angesteuert. Die Basisanschlüsse der Transistoren 52, 62 werden vom komplementären Steuersignal CTRLX angesteuert. Die Kollektoranschlüsse ersterer Transistoren sind über jeweilige Widerstände 53 bzw. 63, an denen die Ausgangssignale OUT bzw. OUTX abgreifbar sind, an das Versorgungspotential VCC angeschlossen. Die Kollektoren der Transistoren 52, 62 sind miteinander gekoppelt und direkt an das Versorgungspotential VCC angeschlossen. Durch die komplementären Komponenten CTRL, CTRLX des Steuersignals ist eine kontinuierliche Einstellung der Verstärkung des Mischers gegeben. Mit beispielsweise abnehmendem Pegel der Steuersignalkomponente CTRL nimmt die Steuersignalkomponente CTRLX zu, so daß zunehmend Strom durch die Transistoren 51, 61 in die Zweige der Transistoren 52, 62 umgeleitet wird und direkt an das Versorgungspotential VCC abgeführt wird. Dadurch nimmt der Pegel an den Lastwiderständen 53, 63 und ebenso die Verstärkung ab. Es kann also durch das Steuersignal CTRL, CTRLX Laststrom vom Strompfad durch die Lastwiderstände 53, 63 abgezogen und direkt an das Versorgungspotential VCC abgeführt werden.

Obwohl die Ausführungsbeispiele bipolare npn-Transistoren enthalten, können die Schaltungen auch mit n-MOS-Transistoren ausgeführt werden. Andererseits ist eine Ausführung auch mit Transistoren der anderen Polarität, also pnp- oder p-MOS-Transistoren möglich. Eine Stromquelle kann aus einem Transistor und einem emitter- bzw. sourceseitigen Gegenkopplungswiderstand aufgebaut sein.

## Patentansprüche

1. Schaltungsanordnung zur Mischung eines Nutzsignals mit einem Oszillatorsignal, mit den Merkmalen:
- Anschlüssen (17, 18, 27, 28) für das Nutzsignal (BB, BBX) ist eine erste (BB) und eine komplementäre zweite (BBX) Signalkomponente des Nutzsignals zuführbar,
- Anschlüssen (31, 41) für das Oszillatorsignal (LO, LOX) ist eine erste (LO) und eine komplementäre zweite (LOX) Signalkomponente des Oszillatorsignals zuführbar,
- ein erster (1) und ein zweiter (2) Differenzverstärker weisen je einen ersten (11; 21) und je einen zweiten (12; 22) Zweig mit jeweils ersten und zweiten Anschlüssen und mit je einem Transistor (11, 12, 21, 22) auf, wobei die ersten Anschlüsse der Zweige über je einen Widerstand (37, 38) mit einem Kopplungsknoten (19; 29; 39) verbunden sind und über eine Stromquelle (3; 4; 34) mit einem Anschluß für ein Bezugspotential (VEE) verbunden sind,
- die Steueranschlüsse der Transistoren (11, 21) der ersten Zweige der Differenzverstärker (1, 2) werden von der ersten Komponente (BB) des Nutzsignals gesteuert und die Steueranschlüsse der Transistoren (12, 22) der zweiten Zweige der Differenzverstärker (1, 2) werden von der zweiten Komponente (BBX) des Nutzsignals gesteuert,
- die zweiten Anschlüsse der ersten und zweiten Zweige verschiedener Differenzverstärker sind jeweils gekoppelt und über ein Lastelement (5, 6) an einen Anschluß für ein Versorgungspotential (VCC) angeschlossen,
**dadurch gekennzeichnet, daß**
jeder der Zweige der Differenzverstärker (1, 2) an einem von der Stromquelle (3, 4) entfernten Anschluß der Widerstände (37, 38) über je einen weiteren Transistor (15, 16, 25, 26) mit dem Anschluß für das Versorgungspotential (VCC) gekoppelt ist und die weiteren Transistoren (15, 16, 25, 26) von je einer der Signalkomponenten des Oszillatorsignals (LO, LOX) steuerbar sind.

2. Schaltungsanordnung nach Anspruch 1,
**dadurch gekennzeichnet, daß**
die Stromquellen (3, 4) Konstantstromquellen sind.

3. Schaltungsanordnung nach Anspruch 1 oder 2,
**dadurch gekennzeichnet, daß**
jeder der Anschlüsse (31, 41) für das Oszillatorsignal (LO, LOX) über je ein kapazitives Element (45, 46, 47, 48) mit den Steueranschlüssen der Transistoren (11, 12, 21, 22) der Differenzverstärker (1, 2) verbunden ist und daß die Zweige der Differenzverstärker (1, 2) einen gemeinsamen Kopplungsknoten (39) aufweisen.

4. Schaltungsanordnung nach Anspruch 3,
**dadurch gekennzeichnet, daß**
die Stromquellen der Differenzverstärker (1, 2) von einer gemeinsamen Stromquelle (34) gebildet sind, durch die der Kopplungsknoten (39) mit dem Anschluß für das Bezugspotential (VEE) verbunden ist

5. Schaltungsanordnung nach einem der Ansprüche 1 bis 4,
**dadurch gekennzeichnet, daß**
die Lastelemente (5, 6) durch je einen Differenzverstärker (51, 52; 61, 62) gebildet sind, von denen ein erster Zweig (51, 61) über je ein weiteres Lastelement (53, 63) an den Anschluß für das Versorgungspotential (VCC) angeschlossen ist und von denen die anderen Zweige (52, 62) lastseitig miteinander gekoppelt sind und an den Anschluß für das Versorgungspotential (VCC) angeschlossen sind, und daß die einen und die anderen Zweige (51, 61; 52, 62) jeweils gemeinsam von einem Steuersignal (CTRL; CTRLX) ansteuerbar sind.

6. Schaltungsanordnung zur Mischung eines Nutzsignals mit einem Oszillatorsignal, mit den Merkmalen:
- Anschlüssen (17, 18, 27, 28) für das Nutzsignal (BB, BBX) ist eine erste (BB) und eine komplementäre zweite (BBX) Signalkomponente des Nutzsignals zuführbar,
- Anschlüssen (31, 41) für das Oszillatorsignal (LO, LOX) ist eine erste (LO) und eine komplementäre zweite (LOX) Signalkomponente des Oszillatorsignals zuführbar,
- ein erster (1) und ein zweiter (2) Differenzverstärker weisen je einen ersten (11; 21) und je einen zweiten (12; 22) Zweig mit jeweils ersten und zweiten Anschlüssen und mit je einem Transistor (11, 12, 21, 22) auf, wobei die ersten Anschlüsse der Zweige über je einen Widerstand (13, 14, 23, 24) mit einem Kopplungsknoten (19; 29; 39) verbunden sind und über eine Stromquelle (3; 4; 34) mit einem Anschluß für ein Bezugspotential (VEE) verbunden sind,
- die Steueranschlüsse der Transistoren (11, 21) der ersten Zweige der Differenzverstärker (1, 2) werden von der ersten Komponente (BB) des Nutzsignals gesteuert und die Steueranschlüsse der Transistoren (12, 22) der zweiten Zweige der Differenzverstärker (1, 2) werden von der zweiten Komponente (BBX) des Nutzsignals gesteuert,
- die zweiten Anschlüsse der ersten und zweiten Zweige verschiedener Differenzverstärker sind jeweils gekoppelt und über ein Lastelement (5, 6) an einen Anschluß für ein Versorgungspotential (VCC) angeschlossen,
**dadurch gekennzeichnet, daß**
jede der Stromquellen (3, 4) eine schaltbare Stromquelle ist, deren einprägbarer Strom in Abhängigkeit von einer der Signalkomponenten des Oszillatorsignals (LO; LOX)abwechselnd ein- und ausschaltbar ist.

## Claims

1. Circuit arrangement for mixing a payload signal with an oscillator signal, comprising the following features:
- connections (17, 18, 27, 28) for the payload signal (BB, BBX) can be supplied with a first signal component (BB) and a complementary second signal component (BBX) of the payload signal,
- connections (31, 41) for the oscillator signal (LO, LOX) can be supplied with a first signal component (LO) and a complementary second signal component (LOX) of the oscillator signal,
- a first differential amplifier (1) and a second differential amplifier (2) each comprises a first branch (11; 21) and each comprises a second branch (12; 22), each comprising first and second connections and each comprising a transistor (11, 12, 21, 22), with the first connections of the branches being connected via a respective resistor (37, 38) to a coupling node (19; 29; 39), and being connected via a current source (3; 4; 34) to a connection for a reference potential (VEE),
- the control connections of the transistors (11, 21) in the first branches of the differential amplifiers (1, 2) are controlled by the first component (BB) of the payload signal, and the control connections of the transistors (12, 22) in the second branches of the differential amplifiers (1, 2) are controlled by the second component (BBX) of the payload signal,
- the second connections of the first and second branches of various differential amplifiers are in each case coupled and are connected via a load element (5, 6) to a connection for a supply potential (VCC),
**characterized in that** each of the branches of the differential amplifiers (1, 2) is coupled to a connection for the supply potential (VCC) via a respective further transistor (15, 16, 25, 26) at a connection of the resistors (37, 38) which is remote from the current source (3, 4), and the further transistors (15, 16, 25, 26) can each be controlled by one of the signal components of the oscillator signal (LO, LOX).

2. Circuit arrangement according to Claim 1,
**characterized in that** the current sources (3, 4) are constant-current sources.

3. Circuit arrangement according to Claim 1 or 2,
**characterized in that** each of the connections (31, 41) for the oscillator signal (LO, LOX) is connected via a respective capacitive element (45, 46, 47, 48) to the control connections of the transistors (11, 12, 21, 22) in the differential amplifiers (1, 2), and **in that** the branches of the differential amplifiers (1, 2) have a common coupling node (39).

4. Circuit arrangement according to Claim 3,
**characterized in that** the current sources of the differential amplifiers (1, 2) are formed by a common current source (34), by means of which the coupling node (39) is connected to the connection for the reference potential (VEE).

5. Circuit arrangement according to one of Claims 1 to 4,
**characterized in that** the load elements (5, 6) are each formed by one differential amplifier (51, 52; 61, 62), of which a first branch (51, 61) is connected via a respective further load element (53, 63) to the connection for the supply potential (VCC), and of which the other branches (52, 62) are coupled to one another on the load side and are connected to the connection for the supply potential (VCC), and **in that** the first branch and the other branches (51, 61; 52, 62) can each be driven jointly by one control signal (CTRL; CTRLX).

6. Circuit arrangement for mixing a payload signal with an oscillator signal, comprising the following features:
- connections (17, 18, 27, 28) for the payload signal (BB, BBX) can be supplied with a first signal component (BB) and a complementary second signal component (BBX) of the payload signal,
- connections (31, 41) for the oscillator signal (LO, LOX) can be supplied with a first signal component (LO) and a complementary second signal component (LOX) of the oscillator signal,
- a first differential amplifier (1) and a second differential amplifier (2) each comprises a first branch (11; 21) and each comprises a second branch (12; 22), each comprising first and second connections and each comprising a transistor (11, 12, 21, 22), with the first connections of the branches being connected via a respective resistor (13, 14, 23, 24) to a coupling node (19; 29; 39), and being connected via a current source (3; 4; 34) to a connection for a reference potential (VEE),
- the control connections of the transistors (11, 21) in the first branches of the differential amplifiers (1, 2) are controlled by the first component (BB) of the payload signal, and the control connections of the transistors (12, 22) in the second branches of the differential amplifiers (1, 2) are controlled by the second component (BBX) of the payload signal,
- the second connections of the first and second branches of various differential amplifiers are in each case coupled and are connected via a load element (5, 6) to a connection for a supply potential (VCC),
**characterized in that**
each of the current sources (3, 4) is a switchable current source, whose current which can be produced can be switched on and off alternately as a function of one of the signal components of the oscillator signal (LO; LOX).

## Revendications

1. Montage de mélange d'un signal utile à un signal oscillateur, ayant les caractéristiques :
- à des bornes (17, 18, 27, 28) pour le signal (BB, BBX) utiles peuvent être envoyées une première composante (BB) et une deuxième composante (BBX) complémentaire du signal utile,
- à des bornes (31, 41) pour le signal (LO, LOX) d'oscillateur peuvent être envoyées une première composante (LO) et une deuxième composante (LOX) complémentaire du signal oscillateur,
- un premier (1) et un deuxième (2) amplificateurs différentiels ont respectivement une première (11; 21) et une deuxième (12; 22) branche ayant respectivement des première et deuxième bornes et ayant respectivement un transistor (11, 12, 21, 22), les premières bornes des branches étant reliées par respectivement une résistance (37, 38) à un noeud (19, 29, 39) de couplage et par une source (3, 4, 34) de courant à une borne pour un potentiel (VEE) de référence,
- les bornes de commande des transistors (11, 21) des premières branches des amplificateurs (1, 2) différentiels sont commandées par la première composante (BB) du signal utile et les bornes de commande du transistor (12, 22) des deuxièmes branches des amplificateurs (1, 2) différentiels sont commandées par la deuxième composante (BBX) du signal utile,
- les deuxièmes bornes des premières et deuxièmes branches des amplificateurs différentiels différents sont couplés respectivement et reliés par un élément (5, 6) de charge à une borne pour un potentiel (VCC) d'alimentation,
**caractérisé en ce que**,
chacune des branches des amplificateurs différentiels (1, 2) est sur l'une des bornes des résistances (37, 38), éloignée de la source (3, 4) de courant, couplée par respectivement un autre transistor (15, 16, 25, 26) à la borne pour le potentiel (VCC) d'alimentation, et les autres transistors (15, 16, 25, 26) peuvent être commandés par respectivement l'une des composantes du signal (LO, LOX) d'oscillateur.

2. Montage selon la revendication 1, **caractérisé en ce que** les sources (3, 4) de courant sont des sources de courant constantes.

3. Montage selon la revendication 1 ou 2, **caractérisé en ce que** chacune des bornes (31, 41) pour le signal (LO, LOX) d'oscillateur est reliée par respectivement un élément (45, 46, 47, 48) capacitif aux bornes de commande des transistors (11, 12, 21, 22) des amplificateurs (1, 2) différentiels et **en ce que** les branches des amplificateurs (1, 2) différentiels ont un noeud (39) commun de couplage.

4. Montage selon la revendication 3, **caractérisé en ce que** les sources de courant des amplificateurs (1, 2) différentiels sont formés par une source (34) de courant commune, par laquelle le noeud (39) de couplage est relié à la borne pour le potentiel (VEE) de référence.

5. Montage selon l'une des revendications 1 à 4, **caractérisé en ce que** les éléments (5, 6) de charge sont formés respectivement par un amplificateur (51, 52; 61,62) différentiel dont une première branche (51, 61) est, par respectivement un autre élément (53, 63) de charge, reliée à la borne pour le potentiel (VCC) d'alimentation et dont les autres branches (52, 62) sont couplées entre elles du côté charge et sont reliées à la borne pour le potentiel (VCC) d'alimentation et **en ce que** les unes et les autres des branches (51, 61; 52, 62) peuvent être commandées en commun par un signal (CTRL ; CTRLX) de commande.

6. Montage de mélange d'un signal utile à un signal d'oscillateur, ayant les caractéristiques :
- à des bornes (17, 18, 27, 28) pour le signal (BB, BBX) utiles peuvent être envoyées une première composante (BB) et une deuxième composante (BBX) complémentaire du signal utile,
- à des bornes (31, 41) pour le signal (LO, LOX) d'oscillateur peuvent être envoyées une première composante (LO) et une deuxième composante (LOX) complémentaire du signal oscillateur,
- un premier (1) et un deuxième (2) amplificateurs différentiels ont respectivement une première branche (11 ; 21) et une deuxième branche (12 ; 22) ayant respectivement des premières et des deuxièmes bornes et respectivement un transistor (11, 12, 21, 22), les premières bornes des branches étant reliées par respectivement une résistance (13, 14, 23, 24) à un noeud (19, 29, 39) de couplage et étant reliées par une source (3, 4; 34) de courant à une borne pour un potentiel (VEE) de référence,
- les bornes de commande des transistors (11, 21) des premières branches des amplificateurs (1, 2) différentiels sont commandées par la première composante (BB) du signal utile et les bornes de commande des transistors (12, 22) des deuxièmes branches des amplificateurs (1, 2) différentiels sont commandées par la deuxième composante (BBX) du signal utile,
- les deuxièmes bornes des premières et deuxièmes branches des amplificateurs différentiels différents sont couplées respectivement et reliées par un élément (5, 6) de charge à une borne pour un potentiel (VCC) d'alimentation,
**caractérisé en ce que**,
- chacune des sources (3, 4) de courant est une source commutable dont le courant, qui peut être appliqué, peut l'être ou ne pas l'être en fonction de l'une des composantes du signal (LO, LOX) d'oscillateur.
